# EUROPEAN PATENT APPLICATION

(11) **EP 1 223 625 A2**
(43) Date of publication of application: **17.07.2002**
(21) Application number: 02075046.9
(22) Date of filing: 08.01.2002
(51) Int. Cl.: H01L 33/00, H01L 21/205

(54) **Nitride semiconductor chip and manufacturing method**

(30) Priority: 11.01.2001 JP 2001003910
(71) Applicant: Sakai, Shiro, Tokushima 770-8072 (JP); Nitride Semiconductors Co., Ltd., Naruto-shi, Tokushima 771-0360 (JP)
(72) Inventor: Shiro, Sakai, Tokushima-shi, Tokushima 770-8072 (JP); Lacroix, Yves, Tokushima-shi, Tokushima 770-0855 (JP)
(74) Representative: Weihs, Bruno

(57) **Abstract**

A method for manufacturing a nitride semiconductor device in which nitride crystals are sequentially grown on a substrate such as sapphire by MOCVD or the like, and p electrode and n electrode are formed. The wafer is not cut along two perpendicular directions, but rather is cut along two directions that form a 120 degree angle, to obtain a rhombus shaped semiconductor chip. Because the wafer has a six-fold rotation symmetry, by cutting the wafer at an angle of 120 degrees, the cutting directions are equivalent and the wafer can be cut in directions along which it can be easily split.

## Description

### BACKGROUND OF THE INVENTION

### 1. Field of the Invention

The present invention relates to a nitride semiconductor device and a method for manufacturing a nitride semiconductor device, and in particular to cutting of a substrate (wafer) onto which nitride crystals are formed.

### 2. Description of the Related Art

In recent years, semiconductor devices have been developed which use nitride crystals such as gallium nitride (GaN) for applications including, for example, light emitting devices such as blue LEDs. Most such nitride crystals are of a wurtzite type having a hexagonal system, with the C axis of the nitride crystals being perpendicular to the substrate plane.

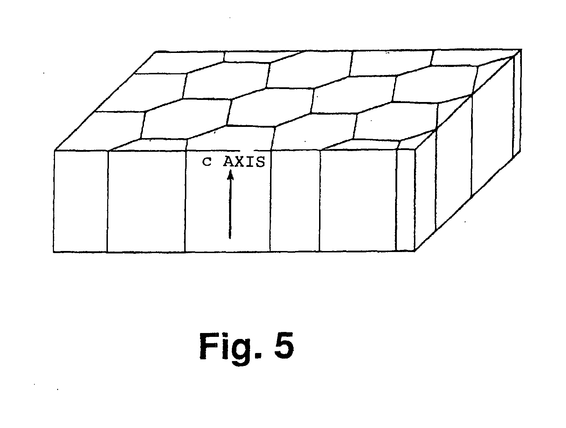

Fig. 5 schematically shows a crystal structure of a nitride crystal. The nitride crystals can be grown on a substrate such as sapphire substrate using a method such as MOCVD. The C axis of the crystals will be perpendicular to the substrate (wafer)surface.

After the crystals are grown using MOCVD or the like, the substrate must be divided or cut into chips for use as devices such as light emitting elements. Commonly, the back surface of the substrate is first ground and then scratches are made on the front or back side of the substrate using a diamond pen or the like. To realize the desired cuts, the substrate is ground to a thickness of 100 µm or less, and preferably to a thickness of 70 µm or less. After the substrate is ground to the desired thickness, the substrate is cut along the direction of the scratches, to thereby create rectangular semiconductor chips.

However, with the above processes grinding the substrate to a thickness of 70 µm so that it will easily split, very easily results in the substrate breaking or splitting during grinding, which is obviously costly and undesirable. To avoid this, a highly precise, very slow grinding process must be performed, which is also expensive and undesirable.

### SUMMARY OF THE INVENTION

The present invention was conceived to solve the above mentioned problem, and one object of the present invention is to provide a method which can simplify the processes of manufacturing a semiconductor by cutting a wafer onto which nitride crystals have been grown. Another object of the present invention is to provide a semiconductor chip which has superior characteristics.

According to one aspect of the present invention, there is provided a manufacturing method comprising the steps of growing nitride crystals having a hexagonal system on a substrate surface, and cutting the substrate in two directions which form a 120 degree angle. By setting the cutting direction for crystals having a hexagonal system, that is, a six-fold rotation symmetry, in two directions that form a 120 degree angle, the two cutting directions are equivalent from the view of the crystal structure, and, thus, when a direction along which the substrate can easily be split is selected for one of the directions, the other direction will as a matter of course also be a direction along which the substrate can easily be split. This facilitates the cutting process and, because the cutting process is facilitated, processes related to the cutting process, such as, for example, substrate grinding processes and the scratching process can also be facilitated.

According to another aspect of the present invention, it is preferable that the semiconductor chip is cut so that the planer shape of the chip becomes a rhombus.

According to another aspect of the present invention, there is provided a semiconductor chip comprising a substrate and nitride crystals having a hexagonal system, formed on the substrate, wherein the planer shape of the semiconductor chip is a rhombus having an interior angle of 120 degrees . This shaping of the chip into a rhombus, facilitates the wafer cutting process as explained above. As a result, chips can be more efficiently manufactured, and wafer usage efficiency can be improved.

According to still another aspect of the present invention, it is preferable that a light emitting section is formed at the central section of the semiconductor chip which is a rhombus, with the electrodes formed to pinch the light emitting section at two ends of the rhombus. By employing this configuration, uniform electric current can be applied throughout the light emitting section, and the light emitting percentage can be improved.

According to a still further aspect of the present invention, sapphire can be used as the substrate. According to yet another aspect of the present invention, GaN, for example, can be used as the nitride crystal. By using GaN, a light emitting element which emits light having a short wavelength can be obtained.

### BRIEF DESCRIPTION OF THE DRAWINGS

Fig. 1 is a diagram for explaining cutting directions according the present invention.
Fig. 2 is a flowchart for the manufacturing method according to the present invention.
Fig. 3A is a plane view of a semiconductor chip according to the present invention.
Fig. 3B is a cross sectional view of the semiconductor chip shown in Fig. 3A.
Fig. 4 is a plane view of a rectangular semiconductor chip.
Fig. 5 is a diagram for explaining a nitride crystal.

### DESCRIPTION OF THE PREFERRED EMBODIMENT

A preferred embodiment of the present invention as exemplified by a light emitting element will be described while referring to the figures.

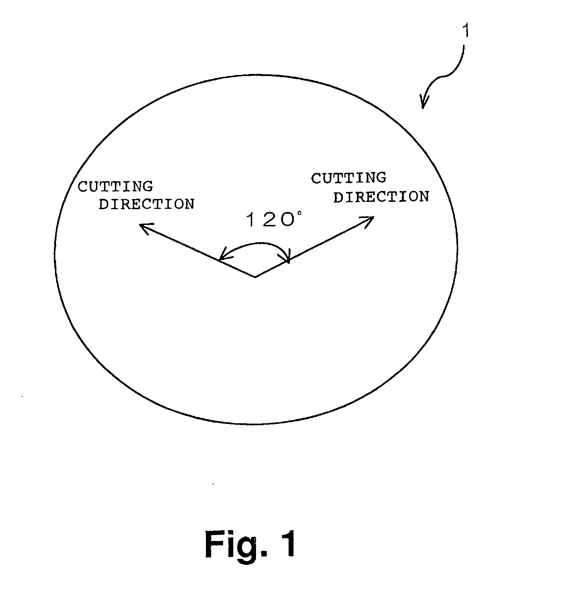

Fig. 1 shows schematically the cutting directions of a substrate (wafer) 1 onto which nitride crystals of hexagonal system are formed. As a substrate, sapphire can be used. As the nitride crystal, gallium nitride (GaN) can be used. More specifically, the element structure can be, substrate/n-GaN layer/InGaN light emitting layer/p-GaN layer, to obtain a light emitting element in a wavelength band between 370 and 550 nm. It is also possible to employ other compositions as the nitride crystal, such as, for example, AlGaN (including a multi-layer quantum well of AlGaN/GaN, a multi-layer quantum well of AlGaN/AlGaN, and a multi-layer quantum well of AlGaN/InGaN) as the n layer, GaN or AlGaN (including a multi-layer quantum well of AlGaN/GaN, multi-layer quantum well of AlGaN/AlGaN, and a multi-layer quantum well of AlGaN/InGaN) as the light emitting layer, and AlGaN as the p layer, to obtain a light emitting element in a wavelength band between 300 and 370 nm.

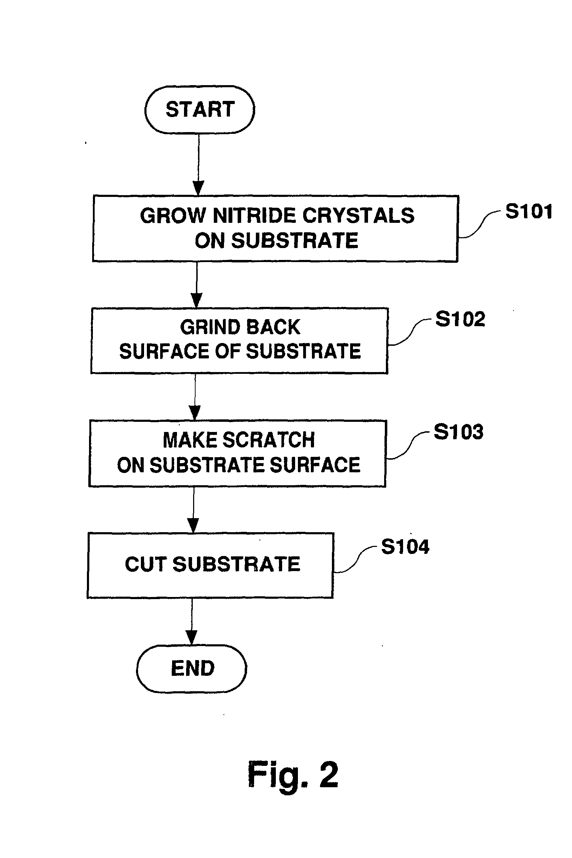

In the embodiment shown in Fig. 1, the wafer is cut along two directions forming a 120 degree angle to create the semiconductor chip of the light emitting element. On the surface of the wafer, a six-fold rotation symmetry is present with the c axis as the rotational axis, and thus, directions that form a 120 degree angle are equivalent from the view of the crystal structure. Therefore, if one direction is selected to be a direction where the wafer can easily be split, for example, a direction along the cleavage surface, the other direction will also be a direction where the wafer can easily be split. As such, cutting of the wafer can be significantly facilitated. Fig. 2 shows a cutting method. First, nitride crystals are grown on a substrate by an MOCVD method or the like (step S101) , the back surface of the substrate is ground (step S102), and a scratch is made on the front or back side of the substrate by a diamond pen or the like (step S103). The substrate is then cut along the direction of the scratch (step S104). In the example of the present embodiment, because the cutting directions are set to be two directions that are equivalent and where the substrate can easily be split, the substrate does not need to be ground to a thickness of 100 µm or less in the grinding process. The substrate can easily be cut even when the thickness is 100 µm or greater. Therefore, the time required for grinding the substrate can be shortened and grinding is not required to be as precise as in the related art. With the present invention, the example sapphire substrate can be cut even when it has a thickness of around 150 µm.

When a substrate not having a cubic structure is cut in directions along which the substrate can easily be split, the cut surface is smoother than it would be if cut in two perpendicular directions. When such a substrate is cut in two perpendicular directions, when one direction is a direction along which the substrate can easily be split, the crystal structure forces the other direction to be one along which the substrate will not readily split. As a result, roughness or unevenness will result along the surface of the second cut.

Also, in general, a large portion of the light emitted from the light emitting layer is channeled to the substrate and emitted from the lateral surfaces. In the example light emitting diode of the present embodiment, because the surface from which light is emitted (the cut surface) is smooth, irregular reflections tend not to occur, and, therefore, the light can be more readily condensed than with conventional devices.

With the method of the preferred embodiment, because the splitting directions are determined by the crystal axis, scratching need not be as precise as required with the conventional art, and a precision of +/- 5 degrees would be sufficient to obtain a chip with superior surface edges. Because scratching of the substrate is therefore simplified, it is possible to narrow the space for scratching and, as a result, to increase the effective light emitting area obtained from a unit area of wafer.

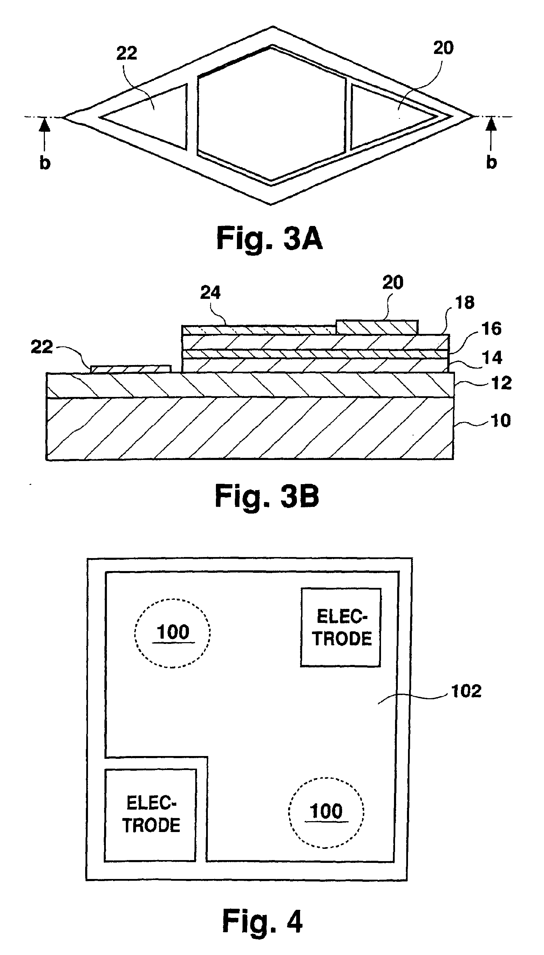

Figs. 3A and 3B show a structure of a single semiconductor chip obtained by cutting a substrate in two direction that form a 120 degree angle as shown in Fig. 1. Fig. 3A is a plane diagram of the chip and Fig. 3B is a cross sectional diagram of the chip along line b-b. As shown in Fig. 3B, n-GaN layers 12 and 14 are formed on a sapphire substrate 10 and an InGaN light emitting layer 16 is formed on the n-GaN layer 14. A p-GaN layer 18 is formed on the light emitting layer 16, and an etching process to partially expose the n-GaN layer 12 is performed so that a p electrode 20 is formed on the p-GaN layer 18 and an n electrode 22 is formed on the n-GaN layer 12. A transparent electrode 24 formed of, for example, ZnO is formed on the p-GaN layer 18 to cover the light emitting layer 16 touching the p electrode 20. The wafer is cut after the p electrode 20, n electrode 22, and transparent electrode 24 have all been formed. A semiconductor chip having a planer shape of rhombus as shown in Fig. 3A is obtained as a result of the cutting process.

The shape of the semiconductor chip according to the preferred embodiment will now be described in detail. The light emitting layer 16 is formed between the n-GaN layer 14 and the p-GaN layer 18. In the plane view, a light emitting section which is a portion of the light emitting layer 16 not covered by the p electrode 20 and that can emit light to the outside via the transparent electrode 24 is positioned at the central section of the rhombus. Triangular p electrode 20 and triangular n electrode 22 are positioned at both ends of the rhombus, that is, two ends of a longer diagonal line among the two diagonal lines of the rhombus. Two electrodes 20 and 22 pinch the light emitting section positioned at the central section of the rhombus. In this manner, by forming a light emitting section at the central section of the rhombus and forming triangular electrodes at the two ends, the effective light emitting area per unit area can be increased compared to a conventional semiconductor chip as shown in Fig. 4 having a square shape and square shaped electrodes formed at its corners.

The following table shows a comparison of the features of the rhombus shaped semiconductor chips of the preferred embodiment with those of conventional square or rectangular shaped semiconductor chips.

| | Rectangular | Rhombus |
|---|---|---|
| Chip Area (A) | 90000 µm² (Length of one Side=300 µm) | 77942 µm² (Length of one side=300 µm) |
| Mesa Area (B) | 260 X 260 µm²=67600 µm² | 60999 µm² (Length of one side=265.4 µm) |
| p Electrode Area (C) | 70 X 70 µm=4900 µm² | 2122 µm²(Equilateral Triangle with 70µm Sides) |
| Etching Area for n Electrode (D) | 80 X 80 µm=6400 µm² | 2122 µm² (Equilateral Triangle with 70 µm Sides) |
| Light Emitting Area (E) E=B-C-D | 56300 µm² | 56755 µm² |
| E/A | 0.625 | 0.728 |

Here, "mesa area" refers to the portion where the p-GaN layer 18 is formed and a gap of 20 µm is formed to surround the mesa. From this table, it can be seen that the light emitting area per unit area, E/A, of the rhombus chip is about 1.2 times that of the conventional rectangular semiconductor chip.

Because the p electrode 20 and the n electrode 22 are placed along the length direction (direction along the longer diagonal line) of the semiconductor chip, the percentage of the regionpinched by both electrodes in the light emitting section is larger and it is easier to apply uniform electric current to the light emitting section than in a case where electrodes are provided at the corners, at both ends of a diagonal line, in a rectangular semiconductor chip as shown in Fig. 4. Thus, the light extraction efficiency can be improved. In order to apply electric current to the region 100 on a diagonal line other than the diagonal line on which electrodes are formed in a rectangular semiconductor chip as shown in Fig. 4, a thick transparent electrode 102 must be formed on the p layer. The example diode according to the present embodiment, on the other hand, does not require formation of such a thick transparent electrode.

In this manner, with the example rhombus shaped semiconductor chip of the preferred embodiment, the structure can be simplified and the light emitting efficiency can be improved. The inventors have found that when light emitting elements of a rectangular shape and of a rhombus shape are prepared under similar conditions, the light emitting efficiency of the rhombus shaped light emitting element is about 1.5 times that of the rectangular light emitting element. The inventors have also confirmed that the number of light emitting elements that can be cut out from and manufactured from one unit of wafer can be increased by about 10 to 20 % when rhomboidal chips are produced.

As described above, according to the present invention, a wafer can be easily cut to produce semiconductor chips. With the semiconductor device according to the present invention, the light emitting efficiency can be improved by forming chips having a planer shape of a rhombus.

## Claims

1. A method for manufacturing a nitride semiconductor chip, said method comprising the steps of:
growing nitride crystals of a hexagonal system on a substrate surface; and
cutting said substrate along two directions that form a 120 degree angle.

2. A method according to claim 1, further comprising, between said growing step and said cutting step, the step of grinding the back surface of said substrate.

3. A method according to claim 2, further comprising the step of:
making scratches on the front or back surface of said substrate, between said grinding step and said cutting step, wherein
said cutting step is performed by cutting said substrate along the directions of said scratches.

4. A method according to claim 1, wherein said semiconductor chip has a planer shape of a rhombus.

5. A method according to claim 1, wherein said substrate is sapphire.

6. A method according to claim 1, wherein said nitride crystals include GaN.

7. A nitride semiconductor chip, comprising:
a substrate; and
nitride crystals of a hexagonal system and formed on said substrate; wherein
the planer shape of said semiconductor chip is a rhombus having an interior angle of 120 degrees.

8. A semiconductor chip according to claim 7, further comprising:
a light emitting section formed on the central section of said rhombus of the planer shape of said semiconductor chip; and
electrode sections formed at both ends of said rhombus to pinch said light emitting section.

9. A semiconductor chip according to claim 8, wherein the planer shape of said electrode sections is triangular.

10. A semiconductor chip according to claim 7, wherein said substrate is sapphire.

11. A semiconductor chip according to claim 7, wherein said nitride crystals include GaN.
